# FASCICULE DE BREVET EUROPEEN

(11) **EP 2 546 188 B1**
(45) Date de publication et mention de la délivrance du brevet: **08.08.2018**
(21) Numéro de dépôt: 12175751.2
(22) Date de dépôt: 10.07.2012
(51) Int. Cl.: B81C 1/00

(54) **Procédé de réalisation d'une structure à membrane suspendue et à électrode enterrée**
Verfahren zur Herstellung einer Struktur mit einer aufgehängten Membran und einer vergrabenen Elektrode
Method for forming a structure with a suspended membrane and a buried electrode

(30) Priorité: 12.07.2011 FR 1156353
(43) Date de publication de la demande: 16.01.2013
(73) Titulaire: Commissariat à l'Énergie Atomique et aux Énergies Alternatives, 75015 Paris (FR)
(72) Inventeur: Giroud, Sophie, 38120 Saint-Egreve (FR); Berthelot, Audrey, 38330 St Ismier (FR); Larrey, Vincent, 38140 La Murette (FR); Polizzi, Jean-Philippe, 38000 Grenoble (FR); Vaudaine, Marie-Hélène, 38180 Seyssins (FR)
(74) Mandataire: Ilgart, Jean-Christophe

(56) Documents cités:
- WO-A1-2010/081603
- US-A1- 2003 001 221
- US-A1- 2007 113 661
- US-B2- 7 083 997
- US-B2- 7 950 288
- YAMAMOTO T ET AL: "CAPACITIVE ACCELEROMETER WITH HIGH ASPECT RATIO SINGLE CRYSTALLINE SILICON MICROSTRUCTURE USING THE SOI STRUCTURE WITH POLYSILICON-BASED INTERCONNECT TECHNIQUE", PROCEEDINGS OF THE IEEE 13TH. ANNUAL INTERNATIONAL CONFERENCE ON MICRO ELECTRO MECHANICAL SYSTEMS. MEMS 2000. MIYAZAKI, JAPAN, JAN. 23-27, 2000; [IEEE INTERNATIONAL MICRO ELECTRO MECHANICAL SYSTEMS CONFERENCE], NEW YORK, NY : IEEE, US, 23 janvier 2000 (2000-01-23), pages 514-519, XP001045369, DOI: 10.1109/MEMSYS.2000.838570 ISBN: 978-0-7803-5274-2

## Description

### DOMAINE TECHNIQUE ET ART ANTERIEUR

L'invention concerne le domaine des semi-conducteurs, plus particulièrement celui des microsystèmes et/ou nanosystèmes et notamment des MEMS/NEMS et leur fabrication collective sur substrat.

Elle concerne notamment le cas où la fabrication du composant MEMS/NEMS nécessite au moins un jeu d'électrodes sous la structure mobile d'un NEMS ou d'un MEMS, et où une connexion électrique est à réaliser entre deux électrodes placées de part et d'autre de cette structure mobile.

Les MEMS ont une gamme étendue d'applications telles que les accéléromètres, les gyromètres, les composant micro-optiques ou encore les composants pour les communications optiques. Ils sont utilisés pour intégrer sur un même substrat des éléments mécaniques et électroniques.

La fabrication d'un MEMS se fait en partant d'un substrat comportant une couche sacrificielle formée dans un premier substrat. La fabrication de ce substrat peut être issue des technologies SOI ou plus simplement faite par dépôt de la couche sacrificielle puis formation de la couche active sur ladite couche sacrificielle. Partant du substrat ainsi constitué on grave des tranchées profondes qui vont définir le composant MEMS. Par exemple dans le cas d'un accéléromètre fonctionnant sur un principe d'activation et détection capacitive on définira des électrodes verticales, couramment appelés peignes, ainsi qu'une masse sismique suspendue, la membrane, et reliée à ces peignes. Cette structure est ensuite rendue mobile en éliminant la couche sacrificielle sous les parties de MEMS à mettre en mouvement.

Certains MEMS comme les gyromètres ou les micro-miroirs sont sensibles à des mouvements en dehors du plan du substrat sur lequel ils sont construits. Ils ont donc besoin d'au moins un jeu d'électrodes placées au-dessus/dessous des éléments mobiles comme on peut le voir dans le document US 7 083 997 ou encore le document US 2010/0193884.

Une des difficultés des composants à électrodes inférieures réside dans la connexion de ces électrodes au reste de l'électronique d'actionnement de MEMS.

Une solution a été apportée dans le document US 2010/0193884. Le contact entre l'électrode inférieure et supérieure se fait alors par l'intermédiaire de deux scellements métalliques, un premier entre le substrat inférieur, dit support, et la couche active, et un second entre la couche active et le substrat supérieur, dit capot, qui supporte l'électrode supérieure. Une des limitations de cette méthode réside dans le premier scellement métallique.

Les matériaux utilisés pour ce scellement ne peuvent être soumis à de fortes températures. Ce scellement interdit, dans la suite de la fabrication du composant, l'utilisation de procédés dit chauds, tels que les procédés d'oxydation thermique par exemple.

Le document US 7083997 présente une méthode de reprise de contact par gravure profonde de vias à travers la couche active, puis à travers la couche sacrificielle pour finalement atteindre la couche conductrice servant d'électrode inférieure. Cette technique est coûteuse, délicate à mettre en ouvre et à contrôler dans le cas de MEMS à fort rapport d'aspect ce qui conduit à des défauts de fiabilité des composants.

Une troisième solution est proposée dans la publication « Capacitive Accelerometer with High Aspect ration single crystalline Silicon Microstructure using the SOI structure with polysilicon-based interconnect technique, T. Yamamoto & al, Proceedings IEEE, Thirteenth Annual International Conference on MEMS, 2000 ». Ces auteurs mettent directement en contact le jeu d'électrodes inférieures et la couche active du MEMS par sa face inférieure du MEMS. Puis ils utilisent la couche active comme une interconnexion pour remonter le contact de l'électrode inférieure vers la surface du MEMS. Cette interconnexion est alors définie et isolée du reste de la structure MEMS par la gravure de tranchées d'isolation dans la couche active. Une des limitations de cette méthode réside dans le choix du matériau de la couche active. En effet, étant donné que cette couche a, entre autre, une fonction d'interconnexion, elle doit avoir un certain niveau de conductivité, ce qui réduit le choix des matériaux utilisables et les applications possibles de la méthode de fabrication présentée. Les MEMS nécessitant des couches actives pas ou peu conductrices ne pourront être fabriqués suivant cette méthode. En outre, cette dernière nécessite de réaliser des tranchées d'isolation.

La technique décrite dans le document T. Yamamoto et al. présente donc des inconvénients, et en particulier l'obligation d'avoir une couche active conductrice pour servir d'interconnexion entre les électrodes inférieures et la surface du MEMS.

Par ailleurs, lors de la fabrication de ces composants à jeu d'électrodes inférieures il est préférable d'avoir un alignement entre ces électrodes inférieures et la structure MEMS elle-même ou avec un jeu d'électrodes supérieures. Pour réaliser cet alignement on utilise couramment des marques d'alignement générées sur la face inférieure du substrat support. Ces marques servent à la fois de repères d'alignement lors de l'assemblage du substrat support avec la couche active, comme décrit dans le document US 2010/0193884, et d'alignement avec les niveaux technologiques réalisés après cet assemblage comme on peut le trouver également dans le document US 7 083 997. Elles nécessitent la réalisation d'étapes technologiques spécifiques et l'utilisation d'équipements spéciaux d'alignement entre la face avant et la face arrière d'un substrat (ou d'assemblage de substrat) ce qui se traduit par un coût sur composant industriel.

L'article de T. Yamamoto & al. , cité ci-dessus, divulgue la création d'une tranchée gravée et remplie d'oxyde. Lors de l'amincissement de la couche active, les marques précédemment créées dans ladite couche active sont mises en évidence, ce qui permet un réalignement direct par la surface supérieure du MEMS.

Cette méthode présente l'avantage de ne pas utiliser d'équipements spéciaux d'alignement face avant/face arrière mais elle nécessite tout de même la réalisation d'étapes spécifiques de formation de ces marques.

### EXPOSÉ DE L'INVENTION

Un dispositif de type micro-système et/ou nano-système, par exemple MEMS et/ou NEMS comporte :
- un premier substrat, ou substrat intermédiaire, comportant une partie mobile,
- un deuxième substrat, ou substrat support,
- au moins une électrode inférieure, en un matériau électriquement conducteur, définie dans une couche d'électrode, et une couche diélectrique, disposées entre le premier et le deuxième substrats, la couche diélectrique étant disposée, en partie ou en totalité, entre l'électrode inférieure et le premier substrat, une partie de la couche diélectrique étant éliminée pour former une cavité sous la partie mobile du système, le fond de cette cavité étant en partie constitué par la surface supérieure d'une partie de l'électrode qui fait face à au moins une partie de la partie mobile;
- le premier substrat comportant des via traversant remplis par le matériau conducteur en contact avec ladite électrode inférieure.

Un tel dispositif peut en outre comporter une électrode supérieure, en contact électrique avec les via traversant du premier substrat. Cette électrode supérieure peut être soit réalisée directement sur le premier substrat, soit reportée par l'intermédiaire d'un troisième substrat sur le premier substrat.

L'électrode inférieure et l'électrode supérieure permettent une détection du mouvement de la partie mobile, hors plan des couches, par variation capacitive. Cependant pour une détection capacitive, une seule électrode peut suffire, bien que l'utilisation d'une deuxième électrode permette d'effectuer une détection avec une meilleure sensibilité.

La conductivité de la couche active n'est pas imposée et peut être quelconque, car l'interconnexion se fait grâce aux vias traversants remplis par un matériau conducteur, et non pas par le premier substrat lui-même.

Ainsi, il est possible d'utiliser une grande variété de couches actives et de substrats, ce qui rend l'invention applicable à de nombreux types de MEMS.

L'électrode supérieure peut être assemblée avec le substrat intermédiaire à l'aide de moyens conducteurs, ou être portée par un 3ème substrat.

Un tel dispositif peut comporter en outre des zones de contact électrique entre l'électrode inférieure et le premier substrat.

Le premier substrat peut être en un matériau semi-conducteur, monocristallin, par exemple en silicium, ou en SiGe ou en SiC ou en SiGeC ou en GaAs ou en Ge on en un matériau semi-conducteur du groupe III-V, de préférence dopé, ou en un substrat de type « silicium sur isolant » (SOI). En variante, le premier substrat comporte plusieurs couches empilées sur un substrat.

Le second substrat est généralement un substrat support tel qu'un substrat massif ou un substrat composite, comme le premier substrat, pour assurer d'autres fonctions. Par ailleurs, ce second substrat peut comporter en surface une couche diélectrique (généralement de l'oxyde).

Une couche diélectrique peut être réalisée entre le deuxième substrat et la couche d'électrode inférieure.

Des zones gravées peuvent être définies dans la couche d'électrode inférieure et dans la couche diélectrique, disposée entre le deuxième substrat et la couche d'électrode inférieure.

Des zones gravées peuvent être définies dans la couche d'électrode inférieure, ces zones gravées étant remplies par le matériau de la couche diélectrique.

Un procédé pour réaliser un dispositif de type micro-système et/ou nano-système, par exemple de type MEMS et/ou NEMS, et en particulier un dispositif tel que décrit ci-dessus, comporte :
a) la formation, sur un premier substrat, d'au moins une première couche diélectrique, d'au moins une électrode inférieure, en un matériau conducteur, définie dans une couche d'électrode inférieure, et de via, remplis par le matériau électriquement conducteur, traversant au moins une partie du premier substrat, de façon à être en contact avec ladite électrode inférieure ;
b) puis, après l'étape a), l'assemblage du premier substrat avec un deuxième substrat, de sorte que la couche d'électrode inférieure, et la première couche diélectrique soient disposées entre le premier et le deuxième substrat, cette couche diélectrique étant disposée entre l'électrode inférieure et le premier substrat ;
c) puis, après l'étape b), la réalisation, dans le premier substrat, d'une partie mobile, en regard de l'électrode inférieure, et la libération de cette partie mobile par élimination, au moins de la partie de la première couche diélectrique disposée sous la partie mobile.

Ce procédé permet de réaliser, au cours de la même étape a), une électrode et son interconnexion à travers la couche active du MEMS.

Il permet de résoudre les problèmes liés à la reprise de contact à travers une couche active de MEMS, notamment dans le cas d'un fort rapport d'aspect et, ainsi, augmente la fiabilité du composant réalisé.

Le rapport d'aspect est défini comme le rapport entre l'épaisseur de la partie active et la plus petite dimension latérale de composant, par exemple celle des entrefers, ou des peignes pour un accéléromètre. On parle de forts rapports d'aspects quand on a un au moins facteur 5, de préférence au moins 10, entre ces dimensions.

Ce procédé peut comporter en outre la formation d'une électrode supérieure, sur le premier substrat, en contact électrique avec les moyens de connexion traversant. Cette électrode supérieure peut être formée sur le premier substrat ou reportée par l'intermédiaire d'un troisième substrat sur le premier substrat.

Ce procédé permet donc de réaliser une connexion entre des électrodes disposées de part et d'autre d'un dispositif MEMS en utilisant des technologies de l'industrie du semiconducteur, sans restrictions sur les matériaux ou les températures de procédés.

En particulier, selon un mode de réalisation, l'étape c) étant réalisée par gravure de motifs traversant le premier substrat, on réalise un remplissage de ces motifs par un matériau sacrificiel, puis on forme l'électrode supérieure, et on grave, au moins partiellement, le matériau sacrificiel et de la première couche diélectrique.

Le remplissage des motifs gravés par la couche sacrificielle permet de déposer la deuxième électrode de façon planaire.

Selon un mode de réalisation, l'étape c) est, là encore, réalisée par gravure de motifs traversant le premier substrat ; on forme, avant l'étape c), des plots conducteurs sur le premier substrat, puis, après l'étape c), l'électrode supérieure, en contact avec ces plots conducteurs.

La formation de plots conducteurs peut comporter :
- le dépôt d'une couche de matériau sacrificiel sur le premier substrat,
- puis la gravure de cette couche de matériau sacrificiel pour définir des zones gravées en regard des moyens de connexion du premier substrat,
- et enfin la formation des plots conducteurs dans, et éventuellement sur, ces zones gravées.

Lorsque les plots conducteurs peuvent être gravés sélectivement vis-à-vis du premier substrat, on ne forme pas la couche sacrificielle.

L'électrode supérieure peut être obtenue par report, par l'intermédiaire d'un troisième substrat, sur le premier substrat. Autrement dit, on forme alors une électrode supérieure par report d'un troisième substrat comportant ladite deuxième électrode de façon à ce que les plots conducteurs soient en contact avec cette électrode.

Le procédé décrit permet de générer, lors des mêmes étapes technologiques, des interconnexions et des marques d'alignement « auto-alignées » sur les électrodes inférieures.

Un tel procédé peut comporter en outre la formation de zones de contact électrique entre l'électrode inférieure et le premier substrat.

Il peut comporter en outre la formation d'une couche diélectrique entre le deuxième substrat et la couche d'électrode inférieure.

Des zones gravées peuvent être définies dans la couche d'électrode inférieure et dans la couche diélectrique disposée entre le deuxième substrat et la couche d'électrode inférieure.

En variante, la couche diélectrique peut être uniforme, des zones gravées étant définies dans la couche d'électrode inférieure, avant de former la couche diélectrique.

Ce procédé peut comporter en outre, avant l'étape c), une étape d'amincissement du premier substrat pour rendre traversant les moyens de connexion. Généralement cette étape d'amincissement permet également de définir l'épaisseur de la partie mobile.

L'étape c) est de préférence réalisée par gravure de motifs traversant le premier substrat.

Un tel procédé permet de simplifier les procédés connus, notamment celui exposé par Yamamoto et al. En effet, il permet, par la réalisation des interconnexions, une reprise d'alignement entre les niveaux technologiques inférieurs (électrodes inférieures) et les niveaux technologiques réalisé en surface sur MEMS.

Il en résulte un procédé plus simple que ceux de l'art antérieur, car comportant moins d'étapes technologiques, ne nécessitant pas d'équipements spécifiques d'alignement, et sans ajouts d'étapes complémentaires, contrairement à la solution proposée par Yamamoto.

### BRÈVE DESCRIPTION DES DESSINS

- La figure 1 représente une structure NEMS/MEMS avec 2 électrodes capacitives parallèles, au dessous et au dessus de la couche active,
- les figures 2A-2I représentent, diverses étapes de réalisation d'un dispositif de type MEMS ou NEMS, dans lequel la couche servant à l'assemblage avec le deuxième substrat comporte des cavités,
- les figures 3A-3D représentent une variante d'étapes de réalisation du procédé des figures 2A - 2I,
- les figures 4A - 4B représentent une variante d'autres étapes de réalisation d'un dispositif de type MEMS ou NEMS, dans lesquelles la couche servant à l'assemblage avec le deuxième substrat est continue ;
- la figure 5 représente vue de dessus simplifiée du substrat intermédiaire, avec une structure mobile ;
- la figure 6 représente une structure de substrat SOI.

### EXPOSÉ DÉTAILLÉ DE MODES DE RÉALISATION PARTICULIERS

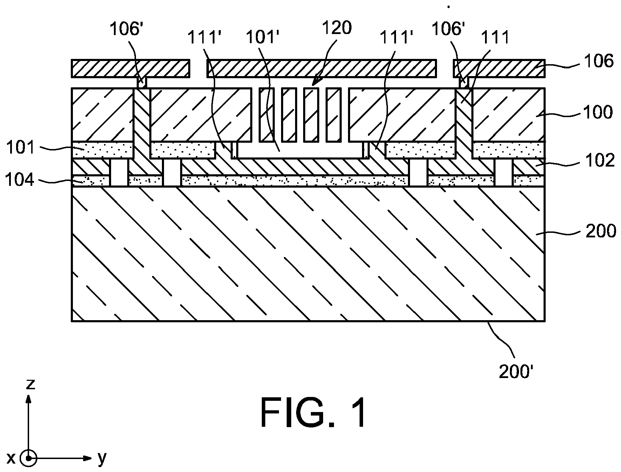

On décrit d'abord un exemple de structure de MEMS/NEMS illustrée en figure 1, qui est une vue en coupe.

Dans la suite, lorsqu'on parle de « substrat » 100, 200, 300, on peut également comprendre une « couche ». Par conséquent, pour ces trois éléments, on utilise indifféremment l'un ou l'autre de ces termes.

La structure de la figure 1 peut être réalisée dans 2 substrats 100, 200, que l'on appellera par la suite respectivement premier substrat et deuxième substrat, superposés et assemblés entre eux préférentiellement par collage direct ou collage moléculaire.

Pour la commodité dans la description, on fera référence à un triangle trirectangle direct xyz, disposé comme indiqué sur la figure 1, c'est-à-dire présentant un axe Z perpendiculaire aux couches ou aux substrats du dispositif, tandis que les deux autres axes x et y, sont perpendiculaires à l'axe Z et perpendiculaires entre eux.

La structure de la figure 1 comporte :
- un premier substrat, ou couche active, 100, dans laquelle est formé la partie mobile, ou active, du MEMS (ou du NEMS) ;
- un substrat support 200, ou deuxième substrat,
- un jeu d'électrodes inférieures 102 et une couche sacrificielle 101, disposée entre le premier substrat et le deuxième substrat, une partie de la couche sacrificielle 101 étant éliminée pour former une cavité 101' sous la partie mobile du système ; le fond de cette cavité est, entre autres, constitué par la surface supérieure d'une partie d'électrode 102 qui fait face à au moins une partie de la zone active du MEMS,
- un jeu d'électrodes supérieures 106, disposées à une certaine distance de la zone active du MEMS et qui fait face à au moins une partie de cette zone active,
- des moyens d'interconnexions 111, qui permettent de relier électriquement la couche d'électrodes inférieures 102 et la couche d'électrodes supérieures 106 à travers le substrat 100.

Comme on le voit sur la figure 1, les connexions 111 ont la forme de plots traversants, par exemple de section, dans le plan xy, cylindrique.

Dans l'exemple choisi, dans le plan xy, ces connexions sont disposées en dehors des parties mobiles du MEMS de part et d'autre de la partie active 120 du MEMS, réalisée dans le substrat 100 dans l'exemple choisi. Leur nombre peut être variable, on en a représenté deux, une de chaque côté de la partie active 120, mais ce nombre peut être quelconque (voire même égal à 1).

Par ailleurs, on peut voir également une ou des connexions 111' entre le jeu d'électrodes inférieur 102 et le substrat 100, ce qui permet de polariser la couche active à certains endroits, par exemple pour limiter des phénomènes de capacités parasites.

Le matériau de l'électrode inférieure 102 peut être un matériau semi-conducteur, de préférence dopé, par exemple du Si amorphe ou poly-cristallin, dopé, ou encore une couche métallique.

Une partie du premier substrat, qui forme la zone active, ou masse mobile 120, est libre de se déplacer, en particulier suivant une direction perpendiculaire à l'axe Z. C'est ce déplacement qui peut être détecté par les électrodes inférieures 102 et supérieures 106.

Dans l'exemple décrit ici, on a un système à détection capacitive. Dans le cas d'un composants RF, par exemple, on a une membrane résistive, formée dans un substrat Si très peu dopé.

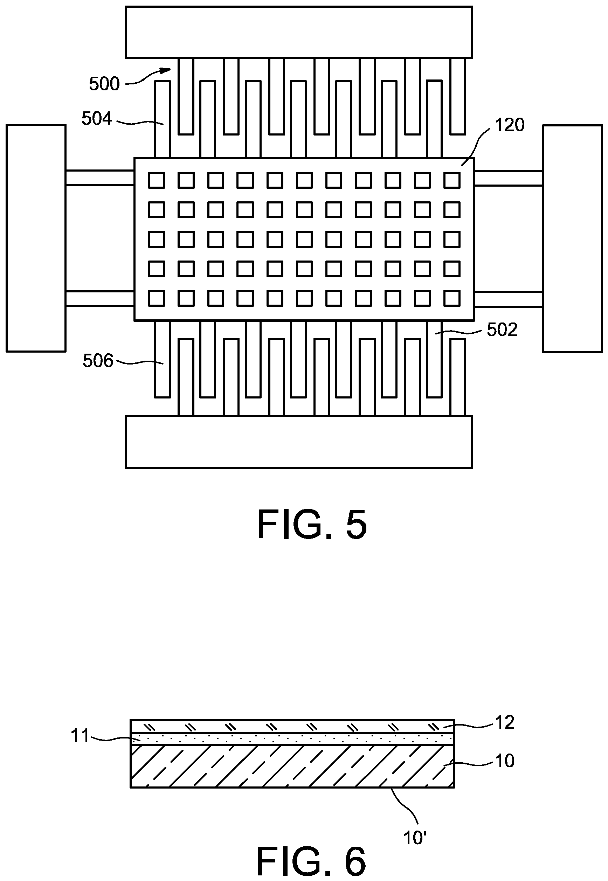

La figure 5 représente une vue de dessus simplifiée du substrat 100, avec un exemple de structure de masse mobile 120, comportant en outre des moyens de détection du mouvement de la masse mobile dans le plan de la couche 120.

La masse mobile peut comporter un ou plusieurs peignes mobiles, en déplacement par rapport à un ou plusieurs peignes fixes.

La structure de cette figure 5 représente une masse mobile 120 munie latéralement de peignes électrostatiques inter-digités, dont certains 500, 506 sont fixes, et d'autre 504, 502 mobile, un peigne mobile 504, 506 étant interdigité avec un peigne fixe 500, 502. Une variation de distance entre un peigne fixe et le peigne mobile qui lui fait face résulte d'un déplacement de ce dernier, qui provient lui même d'un déplacement de la masse mobile 120, et donc du dispositif, conduisant à une variation de capacité détectée par des moyens prévus à cet effet.

D'une manière générale, la partie mobile permet la détection de mouvements imposés au composant.

Par ailleurs, la partie mobile peut comporter une ou plusieurs masses mobiles ou sismiques.

Comme on le voit également sur la figure 1, le niveau d'électrodes supérieures 106 ne repose pas directement sur le substrat 100, mais est relié aux plots 111 par des plots 106' qui maintiennent une certaine distance entre la surface supérieure du substrat 100 et la surface inférieure de la couche d'électrodes 106.

Le substrat 100 a une épaisseur par exemple comprise entre quelques dizaines de µm et quelques centaines de µm, par exemple comprise entre 10 µm et 100 µm ou 500 µm.

Ce substrat s'étend dans le plan xy, l'axe z étant perpendiculaire à chacun des substrats 100, 200. Pour cette raison, le plan xy est aussi appelé plan, ou plan principal, du dispositif.

L'épaisseur du dispositif, mesurée suivant l'axe z, peut être très petite devant les extensions latérales du dispositif, c'est-à-dire devant les dimensions p et 1 de dispositif mesurées dans le plan xy ; p (mesurée selon l'axe x) est par exemple comprise entre 100 µm et quelques mm et 1 (mesurée selon l'axe y) est par exemple de l'ordre de quelques centaines de micromètres, par exemple comprise entre 100 µm et 10000 µm.

Le substrat 100 peut être en un matériau semi-conducteur, préférentiellement monocristallin, mais aussi éventuellement polycristallin. Il est par exemple en silicium, ou en SiGe ou en SiC ou en SiGeC ou en GaAs ou en Ge ou en un matériau semi-conducteur du groupe III-V. Le matériau semi-conducteur - et notamment le silicium - peut être dopé, notamment dans l'exemple ci-dessus, pour permettre une conduction électrique dans la couche active.

En variante, ce substrat 100 peut être un substrat de type « silicium sur isolant » (SOI), comportant, comme on le voit en figure 6, un substrat 10 en matériau semi-conducteur, une couche 11 enterrée d'oxyde et une couche mince semiconductrice 12 par exemple de silicium monocristallin. Ce type de substrat 100 peut être utilisé pour créer différentes fonctionnalités utilisant le caractère monocristallin de la couche 12 par exemple.

On peut également utiliser avantageusement un substrat SOI, dans lequel la couche 101 et l'électrode inférieure 102 seraient formées tout ou partie respectivement par la couche 11 enterrée d'oxyde et la couche mince 12 de silicium, éventuellement dopée. L'intérêt de ce mode de réalisation est notamment la possibilité d'utiliser la couche 11 par exemple comme couche d'arrêt de gravure.

En variante encore, ce substrat peut comporter plusieurs couches empilées sur un substrat semi-conducteur, chaque couche étant par exemple dans l'un ou l'autre des matériaux cités ci-dessus.

L'intérêt est de permettre la réalisation de niveaux d'interconnexions en plus, et/ou d'ajouter des fonctionnalités sous la couche active...

Le substrat 200 peut être par exemple en Si ou en un des autres matériaux semi-conducteurs cités précédemment ou encore en un matériau transparent à la lumière (verre, ou quartz par exemple...), en fonction de la finalité du composant. Il peut éventuellement être recouvert d'une couche de diélectrique (non représentée sur la figure).

On appelle, dans la suite, partie ou côté inférieur du dispositif la partie tournée vers la surface libre 200' du substrat 200 et partie ou côté supérieur du dispositif la partie tournée du côté opposé, du côté des électrodes 106.

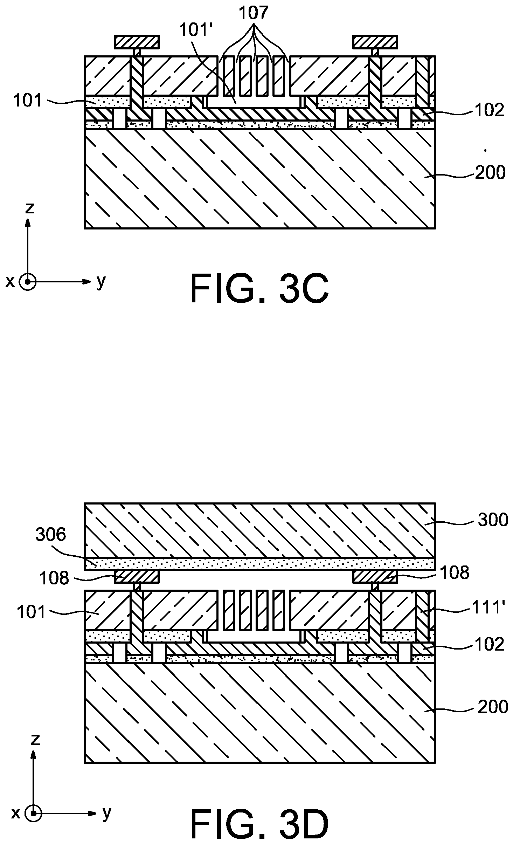

Un autre exemple de structure de MEMS/NEMS est illustrée en figure 3D, qui est aussi une vue en coupe.

La différence avec la structure précédente réside dans la manière dont la couche d'électrodes supérieure 306 est reliée au substrat 100. C'est à l'aide de moyens conducteurs 108, par exemple sous la forme de plots 108 de connexion, que la liaison est établie entre cette couche d'électrodes supérieures et les interconnexions 111 qui traversent le substrat 100.

Les procédés de fabrications décrits ci-dessous ne sont donnés qu'à titre d'exemple et peuvent être appliquée à des composants autres que le composant à détection capacitive utilisée à titre d'illustration.

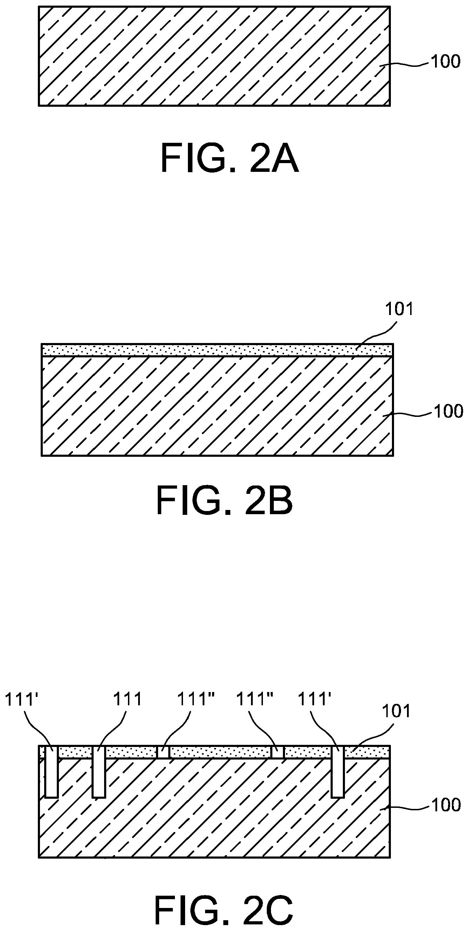

Les figures 2A-2I illustrent un premier exemple d'un procédé pour réaliser un dispositif du type MEMS, à détection capacitive hors plan.

On part (figure 2A) d'un substrat 100 qui peut être constitué de l'un des matériaux déjà mentionnés ci-dessus. C'est dans ce substrat 100 que sera réalisée la partie active du MEMS.

Sur ce substrat 100, on dépose ou fait croître une couche diélectrique 101 (figure 2B), dite couche sacrificielle, par une méthode telle que par exemple l'oxydation thermique, ou par un dépôt CVD, assisté par plasma (PECVD) ou non, ou par ALD (« atomic layer deposition ») ou par IBD (»Ion Beam Deposition »). Cette couche isolante 101 permet d'isoler la future électrode inférieure 102 du premier substrat 100. La fonction de cette couche diélectrique est donc essentiellement une fonction d'isolation électrique mais elle peut aussi servir de couche sacrificielle.

Des étapes de photolithographie et de gravure permettent ensuite (figure 2C), de définir des cavités 111, 111', 111" dans cette première couche diélectrique et, pour certaines d'entre elles, dans le substrat 100. Les cavités 111 permettent ensuite de réaliser, à travers le substrat 100, les moyens de contact entre l'électrode inférieure et l'électrode supérieure du dispositif. Les cavités 111' permettent de réaliser des marques d'alignements (111') traversant le substrat 100, compatibles avec les équipements d'alignement. Ces marques sont ainsi auto alignées avec l'électrode inférieure. Les cavités 111" permettent de réaliser des zones de contact avec le substrat 100 et l'électrode inférieure 102.

La gravure de ces cavités 111, 111' et 111" pourra se faire en une ou plusieurs étapes jusqu'à une profondeur supérieure à l'épaisseur du futur composant MEMS, typiquement de l'ordre de 5 µm à 100 µm ou 200 µm, par exemple, pour un composant dit à fort rapport d'aspect. En d'autres termes, la profondeur des cavités 111, 111' est supérieure ou égale à l'épaisseur qu'aura le substrat 100 après amincissement, comme décrit ci-dessous.

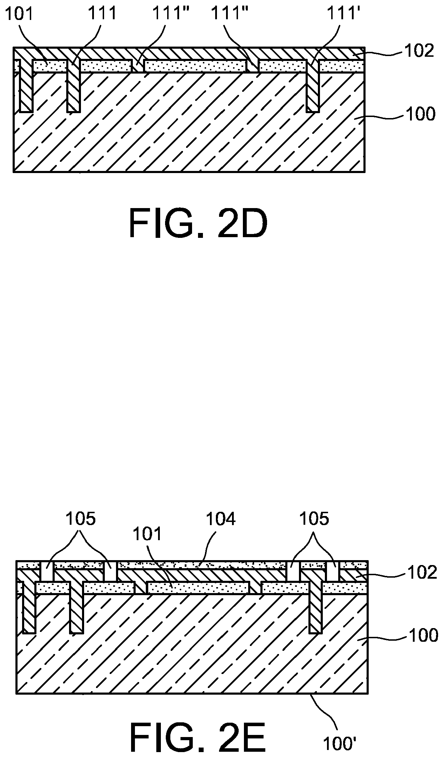

Les cavités sont ensuite remplies par un matériau conducteur 102 (figure 2D). La couche conductrice 102 formée sur la surface supérieure du substrat 100, et que l'on nommera électrode inférieure ou couche d'électrodes inférieures, suivant la géométrie d'électrodes réalisée dans cette couche 102, est créée lors de cette même étape, permettant ainsi un contact de très bonne qualité entre la cavité conductrice et l'électrode inférieure. Les cavités 111' servant aux marques d'alignements sont remplies en même temps que les interconnexions.

La méthode de dépôt de cette couche conductrice de l'électrode inférieure sera choisie en fonction de sa nature : on réalise de ce dépôt par exemple par évaporation, ou par dépôt CVD assisté par plasma ou non, ou encore par pulvérisation. Le dépôt d'une couche de Si dopée par LPCVD est intéressant car compatible avec la grande majorité des procédés utilisés dans une ligne de production de semi-conducteurs, ce qui laisse au concepteur de ce type de MEMS une grande liberté quant au choix des étapes technologiques pour la fabrication complète du composant.

Les cavités 111, 111' peuvent être isolées avant remplissage par le matériau conducteur. Cette isolation pourra se faire par la formation d'un revêtement ou d'une fine couche diélectrique sur les parois de chaque cavité 111, 111', par exemple par oxydation thermique ou par une méthode de dépôt comme le dépôt CVD, assisté par plasma (PECVD) ou non, l'ALD ou l'IBD.

Enfin, l'électrode inférieure 102 peut être amincie, par exemple par gravure physique, ou chimique, ou par polissage mécano-chimique ou par combinaison de ces procédés.

La figure 2E illustre la formation d'une couche de diélectrique 104 au dessus de l'électrode inférieure. Cette couche peut être réalisée par oxydation thermique, ou par dépôt tel que dépôt CVD, assisté par plasma (PECVD) ou non, ou par ALD ou IBD par exemple. Cette couche diélectrique ainsi que la couche conductrice 102 sur laquelle elle est formée peuvent ensuite être gravées pour définir la structure de l'électrode inférieure, comme on le voit en figure 2E avec les zones gravées 105. Le fond des zones gravées correspond sensiblement à la surface de la couche 101.

Dans le cas d'un substrat type SOI (figure 6) la couche superficielle 12 peut former la membrane sur laquelle on viendra réaliser tout ou partie d'un micro ou nanosystème. Le diélectrique 11 du SOI peut servir alors de couche d'arrêt à la gravure des via.

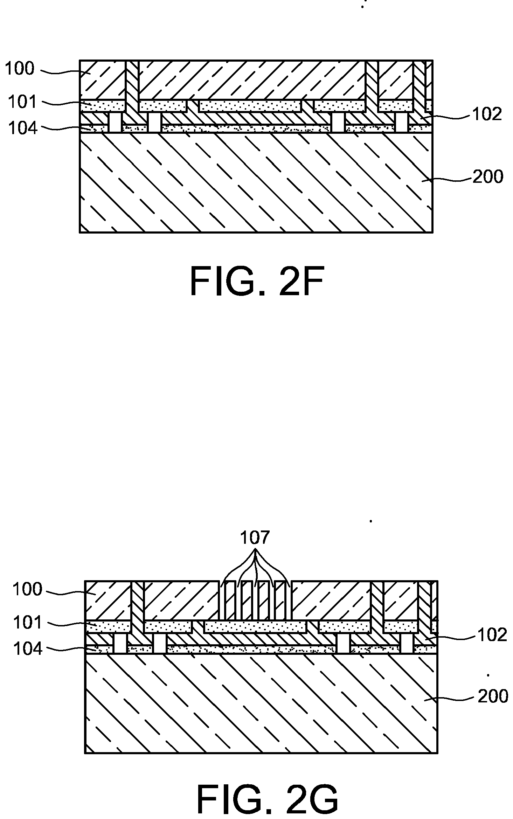

On peut ensuite réaliser un assemblage par scellement de ce substrat 100, ainsi préparé, avec le deuxième substrat 200, de préférence en collage direct (figure 2F). C'est alors la surface de la couche diélectrique 104 qui vient en contact avec le substrat 200, une éventuelle couche isolante ou diélectrique étant formée sur ce substrat 200 ; l'assemblage a alors lieu avec cette couche diélectrique.

Le premier substrat 100, une fois assemblé au deuxième substrat, est aminci (figure 2F) à partir de sa face 100', opposée à l'interface entre les deux substrats 100, 200. Cette étape définit ainsi l'épaisseur du MEMS/NEMS et met à nu les interconnexions 111 et révèle les marques d'alignement 111' .

Cet amincissement pourra faire intervenir seules ou en combinaison, une ou plusieurs des techniques suivantes : gravure chimique, et/ou gravure sèche, et/ou implantation ionique et séparation de substrat (voir par exemple le document EP 763849) et/ou rodage (grinding), et/ou polissage mécano-chimique.

Le premier substrat 100, une fois aminci est gravé verticalement (figure 2G) par sa face supérieure, opposée à l'interface entre les deux substrats 100, 200. Cela permet de former des zones gravées verticales 107 qui traversent le substrat 100 et qui vont définir les parties mobiles de la zone active 120 du dispositif. Le fond des zones gravées correspond sensiblement à la surface de la couche 101.

On définit ainsi la partie active du MEMS.

La gravure mise en oeuvre peut alors être de type RIE et préférentiellement DRIE.

Il est possible d'arrêter le procédé à ce stade, auquel cas on ne réalise pas d'électrode supérieure ni d'assemblage avec un substrat ou capot 300 (figure 3D), et donc il n'y pas de 2^{ème} électrode. En effet, si une électrode inférieure et une électrode supérieure permettent une détection du mouvement de la partie mobile, hors plan des couches, par variation capacitive, une seule électrode peut suffire à cette détection, bien que l'utilisation d'une deuxième électrode permette d'effectuer une détection avec une meilleure sensibilité.

Mais on peut aussi, au contraire, continuer le processus de fabrication avec la formation d'une électrode supérieure.

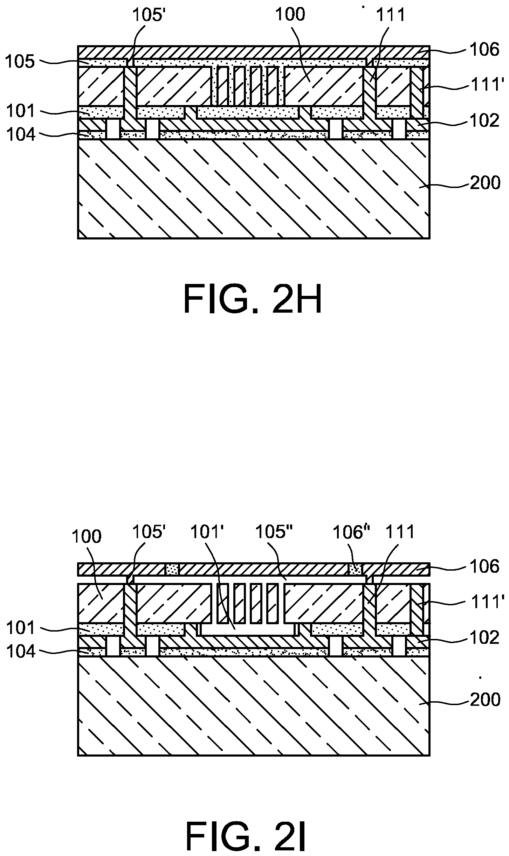

Celle-ci peut donc, ensuite, être réalisée au-dessus de la couche active (figure 2H).

A cette fin, une couche 105 d'oxyde est formée sur la surface supérieure du substrat 100 ; le matériau de cette couche remplit ou bouche les cavités 107 laissées ouvertes lors de la gravure de la structure MEMS.

Au-dessus du sommet des interconnexions 111, on réalise des ouvertures 105' dans la couche 105, afin de préparer la liaison électrique entre l'électrode supérieure et ces interconnexions 111. On peut ensuite déposer une couche de matériau conducteur 106 sur la couche 105. L'épaisseur de la couche 105 définit la distance entre la partie supérieure de la partie active du MEMS et la surface inférieure des électrodes 106.

Cette couche conductrice 106 est ensuite gravée partiellement afin de former des zones traversantes 106". On définit ainsi la structure des électrodes supérieures 106. On peut aussi libérer le MEMS via les ouvertures 106" par élimination par gravure humide, sèche ou en phase vapeur de la couche sacrificielle 105. Les électrodes 106 restent alors seulement en contact avec les interconnexions 111 par les parties de matériau conducteur qui ont été formées dans les zones 105' gravées de la couche 105.

On grave également le matériau diélectrique présent dans les traversées 107 ainsi que la portion de la couche 101 sur laquelle repose la partie active du MEMS, formant ainsi une cavité 101' entre la partie active et la couche inférieure d'électrodes 102.

On obtient alors la structure de la figure 2I, la partie active du MEMS étant libre entre les deux zones gravées 101' et 105".

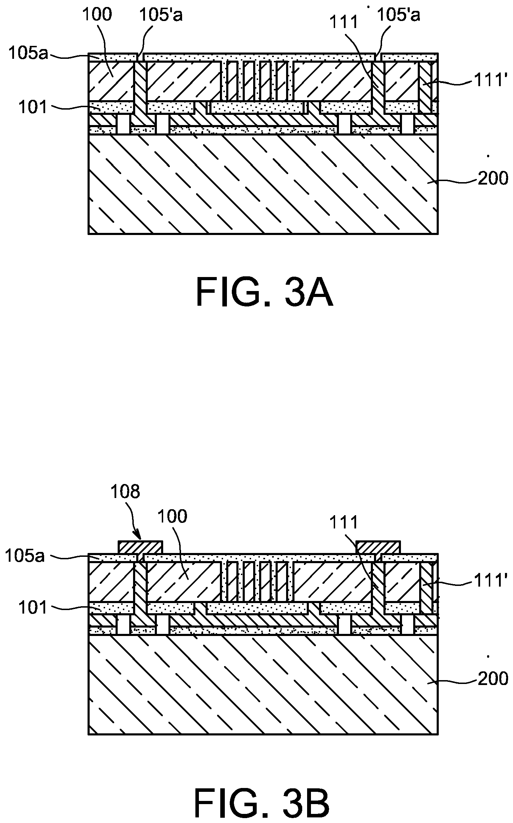

Les figures 3A à 3C présentent un autre exemple de formation de l'électrode supérieure 106a en regard de la couche active.

En partant de la structure obtenue lors de l'étape décrite ci-dessus en liaison avec la figure 2F, une couche d'oxyde 105a est formée sur la surface supérieure du MEMS (figure 3A).

On réalise des ouvertures 105'a dans cette couche 105a, afin de préparer la liaison électrique entre l'électrode supérieure et les interconnexions 111. Des ouvertures 105'a sont donc réalisées au-dessus de ces plots de connexions 111.

Un dépôt de matériau conducteur (ou semi-conducteur), du Ge par exemple, est alors formé sur la couche isolante et dans les ouvertures 105'a, puis gravé pour définir des plots de contact 108 qui dépassent au-dessus de la surface libre de la couche 105a (figure 3B). La hauteur de ces plots et l'épaisseur de la couche 105a peuvent définir la distance qui va séparer la partie supérieure du substrat 100, et donc de la zone active du MEMS, et la surface inférieure de la future électrode 106.

Ensuite la couche 105a, puis le substrat 100, sont gravés verticalement (figure 3C) par la face supérieure, opposée à l'interface entre les deux substrats 100, 200. Cette étape de gravure permet de former des zones gravées verticales 107 qui traversent le substrat 100, mais aussi la portion de la couche 101 disposée entre l'électrode inférieure 102 et la zone active du MEMS. Elle laisse intacts les moyens de connexions qui ont été formés, et en particulier les plots de contact 108. La gravure de la couche 101 aboutit à la formation d'une cavité 101' qui permet de libérer la zone active. Le fond de cette cavité 101' correspond sensiblement à la surface de la couche d'électrodes 102. On définit ainsi la partie active du MEMS. La gravure de la couche 100 peut être de type RIE, de préférence DRIE.

L'électrode supérieure peut ensuite être réalisée au dessus de la couche active (figure 3D).

A cette fin, on assemble ensuite un substrat 300, muni à sa surface d'une couche conductrice 301, qui peut avoir été préalablement gravée et qui va former la future couche d'électrode supérieure. On assemble donc cette couche conductrice avec les extrémités libres des plots 108. L'assemblage est réalisé par scellement métallique sur les plots de contact.

Un capot 300 sans électrode 301 peut aussi présenter un intérêt, dans le cas d'un composant ne fonctionnant qu'avec l'électrode inférieure.

Une variante des étapes décrites ci-dessus en liaison avec les figures 2E - 2F va maintenant être décrite.

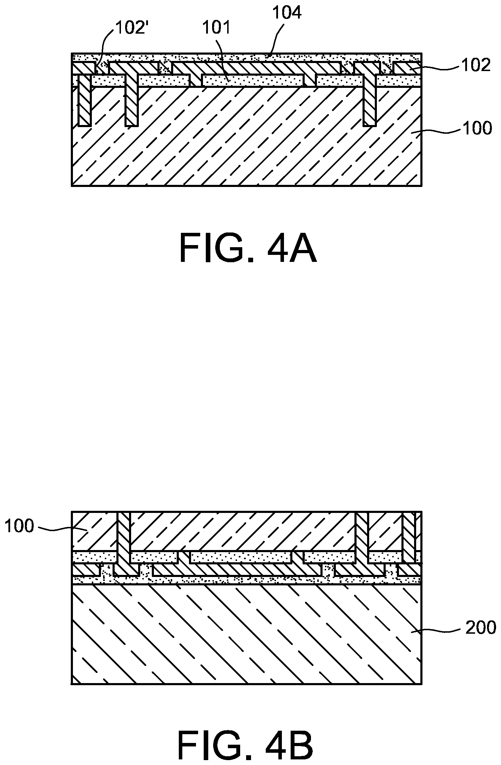

En partant de la structure obtenue à l'issue de l'étape décrite ci-dessus en liaison avec la figure 2D, la couche 102 d'électrodes est gravée, dans des zones 102' (figure 4A). Le fond de ces zones gravées correspond sensiblement à la surface supérieure de la couche 101. Une couche isolante 104, par exemple une couche d'oxyde, est formée sur la surface supérieure de la couche 102. Le matériau de cette couche isolante 104 remplit également les zones 102' qui ont été préalablement gravées. La couche 104 peut être formée par l'une des techniques déjà évoquées ci-dessus.

On peut ensuite réaliser un assemblage par scellement de ce substrat 100, ainsi préparé, avec un deuxième substrat 200, de préférence par collage direct (figure 4B). C'est alors la surface de la couche diélectrique 104 qui vient en contact avec le substrat 200 ; une éventuelle couche isolante ou diélectrique peut être formée sur ce substrat 200, l'assemblage ayant alors lieu avec cette couche diélectrique.

Dans cette variante, la couche 104 reste continue, elle n'est pas gravée. En effet, la gravure de l'électrode 102 intervient avant le dépôt de cette couche 104, à la différence de l'étape de la figure 2E où on dépose d'abord la couche 104 avant de réaliser les zones gravées 105, à la fois dans cette couche et dans la couche d'électrodes 102.

Le substrat 100, une fois assemblé au substrat 200, peut être gravé suivant une direction verticale, comme expliqué ci-dessus en liaison avec la figure 2G. On réalise ensuite les étapes correspondant aux figures 2H-2I. On se reportera à la description faite ci-dessus de ces étapes.

## Revendications

1. Dispositif de type Microsystèmes et/ou Nanosystèmes comportant :
- un premier substrat (100), ou substrat intermédiaire, comportant une partie mobile (120),
- un deuxième substrat (200), ou substrat support,
- au moins une électrode (102), en un matériau électriquement conducteur, définie dans une couche d'électrode, et une couche diélectrique (101), disposées entre le premier et le deuxième substrats, la couche diélectrique étant disposée tout ou partie entre l'électrode et le premier substrat, une partie de la couche diélectrique (101) étant éliminée pour former une cavité sous la partie mobile du système, le fond de cette cavité étant en partie constitué par la surface supérieure d'une partie de l'électrode (102) qui fait face à au moins une partie de la partie mobile;
- le premier substrat (100) comportant (111) des via traversant remplis par le matériau électriquement conducteur en contact avec ladite électrode (102).

2. Dispositif selon la revendication 1 comportant en outre une autre électrode (106, 306), disposée sur le premier substrat (100), et en contact électrique avec les via traversant du premier substrat (100).

3. Dispositif selon la revendication 2, l'autre électrode étant disposée sur le substrat intermédiaire (100) à l'aide de moyens conducteurs (108), ou étant portée par un 3^{ème} substrat (300).

4. Dispositif selon l'une des revendications 1 à 3, comportant en outre des zones de contact (111') électrique entre le premier substrat (100) et l'électrode (102) disposée entre le premier et le deuxième substrats (200).

5. Dispositif selon l'une des revendications 1 à 4, le premier substrat (100) étant en un matériau semi-conducteur, par exemple en silicium, ou en SiGe ou en SiC ou en SiGeC ou en GaAs ou en Ge on en un matériau semi-conducteur du groupe III-V, de préférence dopé, ou en un substrat de type « silicium sur isolant » (SOI) et/ou le premier substrat (100) comportant plusieurs couches empilées sur un substrat.

6. Dispositif selon l'une des revendications 1 à 5, comportant en outre une couche diélectrique (104) entre le deuxième substrat (200) et la couche d'électrode (102) disposée entre le premier (100) et le deuxième substrats.

7. Dispositif selon la revendication précédente, des zones gravées (105) étant définies dans la couche d'électrode (102) disposée entre le premier (100) et le deuxième substrats (200) et dans la couche diélectrique (104) disposée entre le deuxième substrat et ladite couche d'électrode et/ou des zones gravées (102') étant définies dans la couche d'électrode (102) disposée entre le premier et le deuxième substrat, ces zones gravées étant remplies par le matériau de ladite couche diélectrique (104).

8. Procédé pour réaliser un dispositif de type Microsystèmes et/ou Nanosystèmes comportant :
a) la formation, sur un premier substrat (100), d'au moins une première couche diélectrique (101), d'au moins une électrode en un matériau électriquement conducteur, définie dans une couche d'électrode (102), et de via (111), remplis par le matériau électriquement conducteur, traversant le premier substrat (100) de façon à être en contact avec ladite électrode,
b) puis, l'assemblage du premier substrat avec un deuxième substrat (200), de sorte que la couche d'électrode (102), et la première couche diélectrique (101) soient disposées entre le premier et le deuxième substrat, cette première couche diélectrique (101) étant disposée entre l'électrode et le premier substrat,
c) puis, la réalisation, dans le premier substrat, d'une partie mobile (120) en regard de l'électrode et la libération de cette partie mobile par élimination au moins de la partie de la première couche diélectrique disposée sous la partie mobile.

9. Procédé selon la revendication 8, comportant en outre la formation d'une autre électrode (106, 306), sur le premier substrat, en contact électrique avec les vias (111) et/ou avant l'étape c), une étape d'amincissement du premier substrat (100) pour rendre traversant les vias (111).

10. Procédé selon la revendication précédente, l'étape c) étant réalisée par gravure de motifs (107) traversant le premier substrat (100).

11. Procédé selon la revendication précédente, le procédé comportant en outre :
- un remplissage de ces motifs (107) gravés par un matériau sacrificiel (105), la formation de l'autre électrode (106) puis une gravure au moins partielle du matériau sacrificiel (105) et de la première couche diélectrique (101) ;
- ou bien :
* avant l'étape c), la formation de plots conducteurs (108) sur le premier substrat ;
* et, après l'étape c), la formation de l'autre électrode (306), en contact avec les plots conducteurs (108).

12. Procédé selon la revendication 11, la formation de plots conducteurs (108) comportant :
- le dépôt d'une couche de matériau sacrificiel (105a) sur le premier substrat,
- la gravure de cette couche de matériau sacrificiel pour définir des zones gravées (105'a) en regard des vias (111) du premier substrat,
- la formation des plots conducteurs (108) dans, et éventuellement sur, ces zones gravées.

13. Procédé selon l'une des revendications 11 ou 12, l'autre électrode étant formée par report par l'intermédiaire d'un troisième substrat (300), sur le premier substrat.

14. Procédé selon l'une des revendications 11 à 13, comportant en outre la formation de zones de contact (111") électrique entre le premier substrat (100) et l'électrode (102) disposée entre le premier (100) et le deuxième substrats (200)..

15. Procédé selon l'une des revendications 8 à 14, comportant en outre avant l'étape b) d'assemblage, la formation d'une deuxième couche diélectrique (104), pour former un diélectrique entre le deuxième substrat (200) et la couche d'électrode (102) disposée entre le premier (100) et le deuxième substrats, des zones gravées (105) étant définies dans ladite couche d'électrode et dans la deuxième couche diélectrique (104) et/ou l'électrode (102) disposée entre le premier et le deuxième substrats étant réalisée par gravure de la couche d'électrode, des zones gravées (102') étant définies dans cette couche d'électrode, la deuxième couche diélectrique (104), formée après gravure de la couche d'électrode, remplissant lesdites zones gravées.

## Patentansprüche

1. Vorrichtung vom Typ Mikrosysteme und/oder Nanosysteme, umfassend:
- ein erstes Substrat (100), oder Zwischensubstrat, umfassend einen beweglichen Teil (120),
- ein zweites Substrat (200), oder Tragsubstrat,
- wenigstens eine Elektrode (102) aus einem elektrisch leitfähigem Material, die in einer Elektrodenschicht definiert ist, und eine dielektrische Schicht (101), die zwischen dem ersten und dem zweiten Substrat angeordnet sind, wobei die dielektrische Schicht ganz oder teilweise zwischen der Elektrode und dem ersten Substrat angeordnet ist, wobei ein Teil der dielektrischen Schicht (101) entfernt ist, um einen Hohlraum unter dem beweglichen Teil des Systems zu bilden, wobei der Boden dieses Hohlraums teilweise durch die obere Oberfläche eines Teils der Elektrode (102) gebildet ist, die wenigstens einem Teil des beweglichen Teils gegenüberliegt;
- wobei das erste Substrat (100) Durchführungen umfasst (111), die mit dem elektrisch leitfähigen Material gefüllt sind, in Kontakt mit der Elektrode (102).

2. Vorrichtung nach Anspruch 1, ferner umfassend eine weitere Elektrode (106, 306), die auf dem ersten Substrat (100) angeordnet und in elektrischem Kontakt mit den Durchführungen des ersten Substrats (100) ist.

3. Vorrichtung nach Anspruch 2, wobei die weitere Elektrode auf dem Zwischensubstrat (100) mit Hilfe von Leitungsmitteln (108) angeordnet ist oder durch ein drittes Substrat (300) getragen wird.

4. Vorrichtung nach einem der Ansprüche 1 bis 3, ferner umfassend elektrische Kontaktzonen (111') zwischen dem ersten Substrat (100) und der Elektrode (102), die zwischen dem ersten und dem zweiten Substrat (200) angeordnet ist.

5. Vorrichtung nach einem der Ansprüche 1 bis 4, wobei das erste Substrat (100) aus einem Halbleitermaterial ist, beispielsweise aus Silizium, oder aus SiGe oder aus SiC oder aus SiGeC oder aus GaAs oder aus Ge oder aus einem Halbleitermaterial der Gruppe III-V, vorzugsweise dotiert, oder aus einem Substrat vom Typ "Silizium auf Isolator" (SOI), und/oder wobei das erste Substrat (100) mehrere Schichten umfasst, die auf einem Substrat gestapelt sind.

6. Vorrichtung nach einem der Ansprüche 1 bis 5, ferner umfassend eine dielektrische Schicht (104) zwischen dem zweiten Substrat (200) und der Elektrodenschicht (102), die zwischen dem ersten (100) und dem zweiten Substrat angeordnet ist.

7. Vorrichtung nach dem vorhergehenden Anspruch, wobei geätzte Zonen (105) in der Elektrodenschicht (102) definiert sind, die zwischen dem ersten (100) und dem zweiten Substrat (200) angeordnet ist, und in der dielektrischen Schicht (104), die zwischen dem zweiten Substrat und der Elektrodenschicht angeordnet ist, und/oder wobei geätzte Zonen (102') definiert sind in der Elektrodenschicht (102), die zwischen dem ersten und dem zweiten Substrat angeordnet ist, wobei die geätzten Zonen mit dem Material der dielektrischen Schicht (104) gefüllt sind.

8. Verfahren zum Herstellen einer Vorrichtung vom Typ Mikrosysteme und/oder Nanosysteme, umfassend:
a) Bilden, auf einem ersten Substrat (100), wenigstens einer ersten dielektrischen Schicht (101), wenigstens einer Elektrode aus einem elektrisch leitfähigen Material, die in einer Elektrodenschicht (102) definiert ist, und von Durchführungen (111), die mit dem elektrisch leitfähigen Material gefüllt sind, die das erste Substrat (100) durchsetzen, derart, dass sie in Kontakt mit der Elektrode sind,
b) anschließend das Zusammenfügen des ersten Substrats mit einem zweiten Substrat (200) derart, dass die Elektrodenschicht (102) und die erste dielektrische Schicht (101) zwischen dem ersten und dem zweiten Substrat angeordnet sind, wobei diese erste dielektrische Schicht (101) zwischen der Elektrode und dem ersten Substrat angeordnet ist,
c) anschließend die Herstellung eines beweglichen Teils (120) in dem ersten Substrat gegenüber der Elektrode und die Freisetzung dieses beweglichen Teils durch Entfernen wenigstens des Teils der ersten dielektrischen Schicht, der unter dem beweglichen Teil angeordnet ist.

9. Verfahren nach Anspruch 8, ferner umfassend die Bildung einer weiteren Elektrode (106, 306) auf dem ersten Substrat in elektrischem Kontakt mit den Durchführungen (111), und/oder vor dem Schritt c) einen Schritt des Abdünnens des ersten Substrats (100), um die Durchführungen (111) durchgängig zu machen.

10. Verfahren nach dem vorhergehenden Anspruch, wobei der Schritt c) durch Ätzen von Motiven (107) realisiert wird, die das erste Substrat (100) durchsetzen.

11. Verfahren nach dem vorhergehenden Anspruch, wobei das Verfahren ferner umfasst:
- ein Füllen dieser geätzten Motive (107) mit einem Opfermaterial (105), das Bilden der weiteren Elektrode (106) und anschließend ein wenigstens partielles Ätzen des Opfermaterials (105) und der ersten dielektrischen Schicht (101);
- oder aber;
* vor dem Schritt c) das Bilden von Leiterpunkten (108) auf dem ersten Substrat;
* und, nach dem Schritt c), das Bilden der weiteren Elektrode (306) in Kontakt mit den Leiterpunkten (108).

12. Verfahren nach Anspruch 11, wobei das Bilden von Leiterpunkten (108) umfasst:
- das Aufbringen einer Schicht aus Opfermaterial (105a) auf dem ersten Substrat,
- das Ätzen dieser Schicht aus Opfermaterial, um geätzte Zonen (105'a) gegenüber den Durchführungen (111) des ersten Substrats zu definieren,
- das Bilden der Leiterpunkte (108) in und gegebenenfalls auf diesen geätzten Zonen.

13. Verfahren nach einem der Ansprüche 11 oder 12, wobei die weitere Elektrode durch Übertragung mittels eines dritten Substrats (300) auf das erste Substrat gebildet wird.

14. Verfahren nach einem der Ansprüche 11 bis 13, ferner umfassend die Bildung von elektrischen Kontaktzonen (111") zwischen dem ersten Substrat (100) und der Elektrode (102), die zwischen dem ersten (100) und dem zweiten Substrat (200) angeordnet ist.

15. Verfahren nach einem der Ansprüche 8 bis 14, ferner umfassend vor dem Schritt b) des Zusammenfügens die Bildung einer zweiten dielektrischen Schicht (104), um ein Dielektrikum zu bilden zwischen dem zweiten Substrat (200) und der Elektrodenschicht (102), die zwischen dem ersten (100) und dem zweiten Substrat angeordnet ist, wobei geätzte Zonen (105) in der Elektrodenschicht und in der zweiten dielektrischen Schicht (104) definiert sind, und/oder wobei die Elektrode (102), die zwischen dem ersten und dem zweiten Substrat angeordnet ist, durch Ätzen der Elektrodenschicht realisiert wird, wobei geätzte Zonen (102') in dieser Elektrodenschicht definiert sind, wobei die zweite dielektrische Schicht (104), die nach dem Ätzen der Elektrodenschicht gebildet wird, die geätzten Zonen auffüllt.

## Claims

1. Microsystem and/or nanosystem type device comprising:
- a first substrate (100), or intermediate substrate, comprising a mobile part (120),
- a second substrate (200) or support substrate,
- at least one electrode, in an electrically conducting material, and one dielectric layer (101), located between the first and second substrates, the dielectric layer being arranged in part or in whole between the electrode and the first substrate, part of the dielectric layer (101) being eliminated to form a cavity under the mobile part of the system, the bottom of this cavity being formed partly by the upper surface of an electrode (102) that faces at least part of the mobile part,
- the first substrate (100) comprising (111) through vias filled with the electrically conducting material in contact with said lower electrode (102).

2. Device according to claim 1 also comprising another electrode (106, 306), located on the first substrate (100), and in electrical contact with the vias passing through the first substrate (100).

3. Device according to claim 2, the other electrode being located on the intermediate substrate (100) using conducting means (108), or being supported by a 3rd substrate (300).

4. Device according to any one of claims 1 to 3, also comprising electrical contact zones (111') between the first substrate (100) and the electrode (102) located between the first and second substrates (200).

5. Device according to any one of claims 1 to 4, the first substrate (100) being made of a semiconducting material, for example silicon, or SiGe or SiC or SiGeC or GaAs or Ge or a semiconducting material of Group III-V, preferably doped, or a "silicon on insulator" (SOI) type substrate and/or the first substrate (100) comprising several layers stacked on a substrate.

6. Device according to any one of claims 1 to 5, also comprising a dielectric layer (104) between the second substrate (200) and the electrode layer (102) located between the first (100) and second substrates.

7. Device according to the previous claim, etched zones (105) being defined in the electrode layer (102) located between the first (100) and second substrates (200) and in the dielectric layer (104) located between the second substrate and said electrode layer and/or etched zones (102') being defined in the electrode layer (102) located between the first (100) and second substrates, these etched zones being filled with the material of said dielectric layer (104).

8. Method for making a microsystem and/or nanosystem type device, comprising:
a) forming on a first substrate (100) at least one first dielectric layer (101), at least one electrode in an electrically conducting material, defined in an electrode layer (102), and vias (111) filled with the electrical conducting material and passing through the first substrate (100) to come into contact with said electrode,
b) then assembling the first substrate with a second substrate (200), such that the electrode layer (102) and the first dielectric layer (101) are located between the first and the second substrates, this first dielectric layer (101) being located between the electrode and the first substrate,
c) then producing a mobile part (120) in the first substrate, facing the lower electrode and release of this mobile part by elimination of at least part of the first dielectric layer located under the mobile part.

9. Method according to claim 8, also comprising forming another electrode (106, 306) on the first substrate, in electrical contact with the through vias (111) and/or a step of thinning the first substrate (100) before step c) to make the vias pass through.

10. Method according to the previous claim, step c) being made by etching patterns (107) through the first substrate (100).

11. Method according to the previous claim, the method also comprising:
- filling of these etched patterns (107) by a sacrificial material (105), forming the other electrode (106) and then at least partial etching of the sacrificial material (105) and the first dielectric layer (101)
- or
* forming conducting pads (108) on the first substrate before step c);
* then, forming the other electrode (306) in contact with these conducting pads (108) after step c).

12. Method according to claim 11, the formation of conducting pads (108) comprising:
- deposing a layer of sacrificial material (105a) on the first substrate,
- etching this layer of sacrificial material to define etched zones (105'a) facing vias (111) of the first substrate,
- forming conducting pads (108) in and possibly on these etched zones.

13. Method according to either claim 11 or 12, the other electrode being formed by transfer onto the first substrate through a third substrate (300).

14. Method according to any one of claims 11 to 13, also comprising forming electrical contact zones (111'') between the first substrate (100) and the electrode (102) located between the first (100) and second substrates (200).

15. Method according to any one of claims 8 to 14, also comprising, before the assembly step b), forming a second dielectric layer (104) to form a dielectric between the second substrate (200) and the electrode layer (102) located between the first (100) and second substrates, etched zones (105) being defined in said electrode layer and in the second dielectric layer (104) and/or the electrode (102) located between the first and second substrates being made by etching the electrode layer, etched zones (102') being defined in this electrode layer, the second dielectric layer (104), formed after etching of the electrode layer, filling said etched zones.
